(19) Europäisches Patentamt
European Patent Office
Office européen des brevets

(11) **EP 0 533 230 B1**

(12) **FASCICULE DE BREVET EUROPEEN**

(45) Date de publication et mention
de la délivrance du brevet:
**07.01.1998 Bulletin 1998/02**

(51) Int Cl.6: **H03F 3/45**

(21) Numéro de dépôt: **92202523.4**

(22) Date de dépôt: **18.08.1992**

(54) **Amplificateur différentiel et mélangeur oscillateur l'incorporant**

Differenzverstärker, Oszillator und Mischer

Differential amplifier and mixer oscillator incorporating the same

(84) Etats contractants désignés:
**DE FR GB IT**

(30) Priorité: **21.08.1991 FR 9110481**

(43) Date de publication de la demande:
**24.03.1993 Bulletin 1993/12**

(73) Titulaires:
- **PHILIPS COMPOSANTS ET
  SEMICONDUCTEURS
  92150 Suresnes (FR)**
  Etats contractants désignés:
  **FR**
- **Philips Electronics N.V.
  5621 BA Eindhoven (NL)**
  Etats contractants désignés:
  **DE GB IT**

(72) Inventeur: **Chevallier, Gilles,
Société Civile S.P.I.D.
F-75008 Paris (FR)**

(74) Mandataire: **Charpail, François et al
Société Civile S.P.I.D.
156, Boulevard Haussmann
75008 Paris (FR)**

(56) Documents cités:
**EP-A- 0 275 079          EP-A- 0 414 328
FR-A- 2 640 094**

**Description**

La présente telle que définie dans les revendications invention a pour object un amplificateur différentiel du type cascode comprenant un étage différentiel comportant un premier et un deuxième transistor dont les collecteurs sont connectés à une charge active constituée par le trajet collecteur-émetteur respectivement d'un troisième et d'un quatrième transistor en série respectivement avec une première et une deuxième résistance dont une borne est connectée à une première source de tension d'alimentation, les troisième et quatrième transistors ayant leur base connectée à une source de tension de référence.

De tels amplificateurs sont largement connus et utilisés. Un problème de ces amplificateurs est leur relation entre linéarité et tension d'alimentation. Pour une tension d'alimentation donnée, il peut être souhaité d'améliorer leur linéarité, ou bien pour une linéarité donnée, il peut être souhaité d'abaisser leur tension d'alimentation. La demande de brevet français FR-A-2640094, déposée par la Demanderesse le 6 décembre 1988, propose un élément de solution à ce problème.

La présente invention a pour objet un fonctionnement amélioré des amplificateurs du type précité.

L'idée de base consiste à produire un fonctionnement de l'amplificateur différent en continu et en alternatif.

Un amplificateur différentiel selon l'invention est ainsi caractérisé en ce qu'il comporte un premier condensateur disposé entre le trajet collecteur-émetteur du troisième et du premier transistor, ainsi qu'un deuxième condensateur disposé entre les trajets collecteur-émetteur du quatrième et du deuxième transistor, en ce qu'il comporte une troisième et une quatrième résistance disposée entre ladite source de tension d'alimentation et le trajet collecteur-émetteur de respectivement le premier et le deuxième transistor et en ce qu'il comporte une première et une deuxième source de courant connectée à l'émetteur respectivement des troisième et quatrième transistors de manière à fournir un courant au troisième et au quatrième transistor. Ces sources de courant peuvent être constituées par une cinquième et une sixième résistance connectée entre l'émetteur respectivement du troisième et du quatrième transistor et une deuxième source de tension d'alimentation (par exemple la masse).

L'invention concerne également un mélangeur-oscillateur comportant un mélangeur attaquant les entrées d'un amplificateur différentiel tel que défini ci-dessus, et dont les sorties sont connectées à un filtre. Le mélangeur est avantageusement couplé directement aux entrées de l'amplificateur différentiel. Selon un mode de réalisation préféré, le mélangeur est couplé aux sorties de l'amplificateur différentiel à travers uniquement une cinquième et une sixième résistance.

L'invention sera mieux comprise à la lecture de la description qui va suivre, donnée à titre d'exemple non limitatif, en liaison avec les dessins qui représentent :

- la figure 1, un mélangeur-oscillateur selon la demande de brevet français FR-A-2640094 précitée,
- la figure 2, un amplificateur différentiel selon l'invention,
- la figure 3, un mélangeur-oscillateur selon un mode de réalisation de l'invention,
- et la figure 4, un mélangeur-oscillateur selon un mode de réalisation préféré de l'invention.

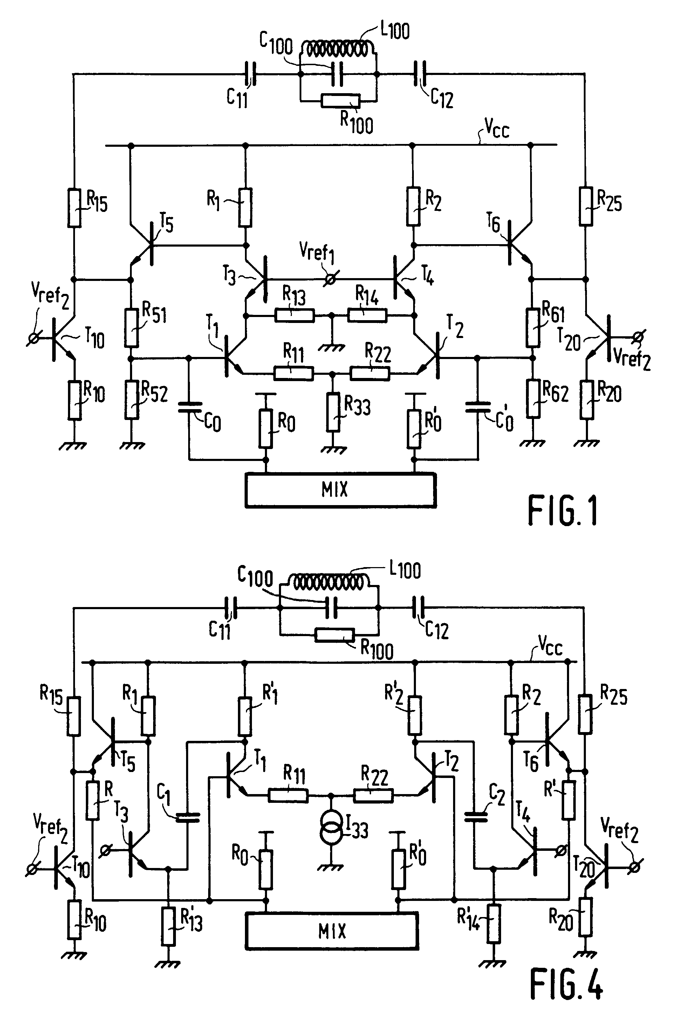

Selon la figure 1, un amplificateur utilisable comme amplificateur de fréquence intermédiaire (FI) pour les signaux d'un mélangeur (MIX) comporte deux transistors $T_1$ et $T_2$ formant une paire différentielle (couplage entre les émetteurs par deux résistances $R_{11}$ et $R_{22}$ en série, source de courant $R_{33}$ (notamment une résistance connectée au point commun à $R_{11}$ et $R_{22}$). Les transistors de cascode $T_3$ et $T_4$, dont les bases sont interconnectées et portées au potentiel de référence $V_{ref1}$, ont leur trajet collecteur-émetteur disposé entre les trajets collecteur-émetteur respectivement de $T_1$ et $T_2$ et une source de tension d'alimentation $V_{cc}$. Des sources de courant ($R'_{13}$, $R'_{14}$) apportent de manière séparée une partie du courant statique de la paire différentielle ($T_1$, $T_2$).

Des transistors $T_5$ et $T_6$ sont montés en émetteur-suiveur à partir des collecteurs des transistors respectivement $T_3$ et $T_4$, leur base étant connectée à cet effet au collecteur respectivement des transistors $T_3$ et $T_4$. Les collecteurs de $T_5$ et $T_6$ sont connectés à la source de tension d'alimentation $V_{cc}$. Les émetteurs de $T_5$ et $T_6$ sont connectés à une source de courant respectivement ($R_{10}$, $T_{10}$) et ($R_{20}$, $T_{20}$), les transistors $T_{10}$ et $T_{20}$ ayant à cet effet leur base portée à un potentiel de référence $V_{ref\,2}$. Une contre-réaction, destinée à obtenir un amplificateur à transimpédance, est réalisée grâce à deux ponts diviseurs à résistance d'une part ($R_{51}$, $R_{52}$) et d'autre part ($R_{61}$, $R_{62}$). Le premier pont diviseur ($R_{51}$, $R_{52}$) est disposé entre l'émetteur de $T_5$ et le pôle de mode commun (masse). Le deuxième pont diviseur ($R_{61}$, $R_{62}$) est disposé entre l'émetteur de $T_6$ et le pôle de mode commun (masse).

Le filtre de l'amplificateur FI est constitué par un circuit parallèle $L_{10}$, $C_{10}$, $R_{10}$ connecté aux émetteurs de $T_5$ et $T_6$ à travers deux résistances $R_{15}$ et $R_{25}$.

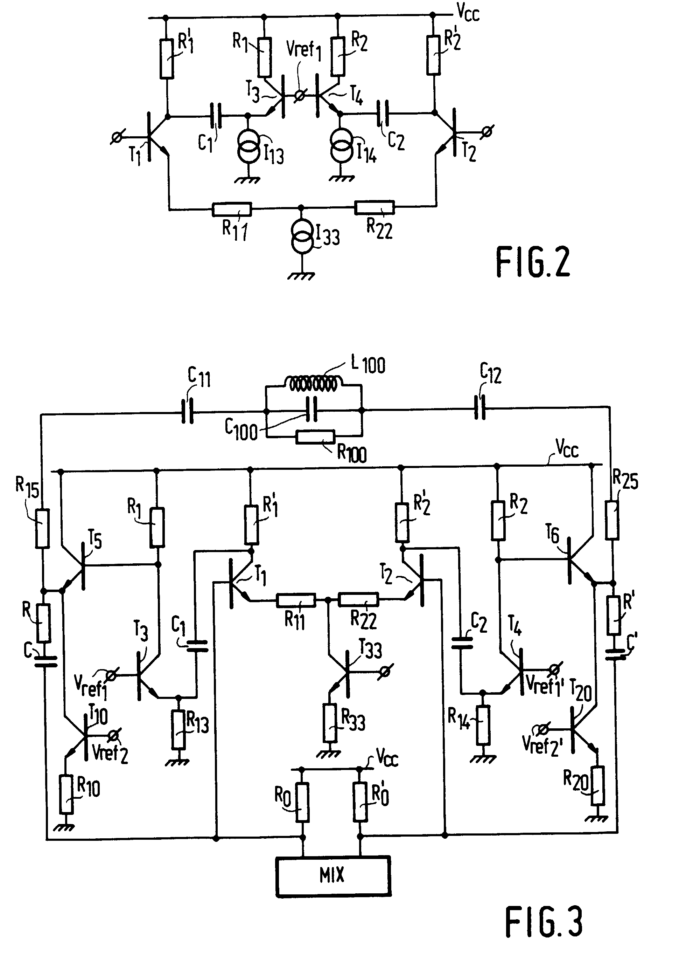

Selon la figure 2, un amplificateur selon l'invention comporte, comme dans la figure 1, une paire différentielle ($T_1$, $T_2$, $R_{11}$, $R_{22}$, $I_{33}$) et des transistors de cascode $T_3$ et $T_4$ dont les bases sont interconnectées (point B) et portées à la tension $V_{réf\,1}$. Le collecteur de $T_3$ et $T_4$ est relié à la source de tension d'alimentation $V_{cc}$ à travers des résistances $R_1$ et $R_2$. Le collecteur de $T_1$ et $T_2$ est relié à la source de tension $V_{cc}$ à travers les résistances $R'_1$ et $R'_2$.

Des sources de courant ($I'_{13}$, $I'_{14}$) sont disposées dans les émetteurs respectivement de $T_3$ et $T_4$ pour fournir un courant à $T_3$ et $T_4$. Il s'agit ici de courants de polarisation dont la valeur n'est pas critique.

Les trajets collecteur-émetteur de $T_3$ et $T_4$ sont connectés en série avec ceux des transistors $T_1$ et $T_2$ à travers des condensateurs respectivement $C_1$ et $C_2$.

Dès que les termes $\frac{1}{jC_1\omega}$ et $\frac{1}{jC_2\omega}$ sont suffisamment faibles (avec $\omega = 2\pi f$, f désignant la fréquence de fonctionnement du circuit), l'effet Miller des transistors $T_1$ et $T_2$ est réduit de la même manière que dans un amplificateur à cascode classique.

Par contre, la présence des condensateurs $C_1$ et $C_2$ fait que, en courant continu, le collecteur de $T_1$ (ou de $T_2$) est à un potentiel supérieur à celui de l'émetteur de $T_3$ (ou de $T_4$). En d'autres termes, la tension de polarisation $V_{cc}$ peut, toutes choses égales par ailleurs, être plus faible que dans un montage cascode classique où on doit tenir compte de deux trajets collecteur-émetteur en série. On peut dire que, selon l'invention, les transistors de la paire différentielle et les transistors de cascode fonctionnent "en série" en courant alternatif et en "parallèle" du point de vue polarisation.

Si on raisonne à tension d'alimentation $V_{cc}$ égale, il est possible, par rapport à l'art antérieur, d'abaisser la valeur des résistances $R'_1$ et $R'_2$ (puisque le collecteur de $T_1$ et $T_2$ peut être à un potentiel plus élevé qu'auparavant). On obtient alors une polarisation des transistors $T_3$ et $T_4$ permettant des tensions collecteur-émetteur plus importantes que précédemment et donc une augmentation de la linéarité. En outre, il devient possible d'introduire à la place de $R_{33}$ une source de courant $I_{33}$ ce qui permet une suppression quasi-parfaite des signaux de mode commun en sortie.

Enfin, l'amplificateur présente des gains différents en continu et en alternatif.

En courant continu, le gain $G_{DC}$ vaut :

$$G_{DC} = \frac{R_1'}{R_{11}} = \frac{R_2'}{R_{12}}$$

En courant alternatif, le gain $G_{AC}$ vaut :

$$G_{AC} = \frac{R_1}{R_{11}} = \frac{R_2}{R_{12}}$$

Et comme il l'a été indiqué ci-dessus, la valeur de $R'_1$ et de $R'_2$ est avantageusement diminuée, on obtient facilement une valeur nettement plus faible pour $G_{DC}$ que pour $G_{AC}$, ce qui permet d'éviter de contre-réactionner l'amplificateur en continu, étant donné que les tensions de décalage à l'entrée ("offset") ne sont plus gênantes.

Exemple :

$$V_{cc} = 5\text{ V } R'_1 = R'_2 \simeq 1\text{ k}\Omega\ R_1 = R_2 = 5\text{ k}\Omega$$

$R_{11} = R_{12} = 50\Omega$. Tension de polarisation de collecteur de $T_1$ et $T_2$ = 3,8 V. Tension de polarisation d'émetteur de $T_3$ et $T_4$ = 0,7 V. $V_{ref1}$ = 1,4 V.

Selon la figure 3, les sources de courant $I'_{13}$ et $I'_{14}$ sont respectivement des résistances $R'_{13}$ et $R'_{14}$ connectées entre l'émetteur respectivement de $T_3$ et $T_4$ et la masse. On remarquera que la tension d'émetteur de $T_3$ et $T_4$ est relativement constante car elle ne diffère de $V_{ref\,1}$ que par la tension base-émetteur de $T_3$ et $T_4$ qui varie peu en fonction du courant qui les traverse.

Comme dans le cas de la figure 1, on a également représenté les transistors $T_5$ et $T_6$, les résistances $R_{15}$ et $R_{25}$, et les sources de courant $(R_{10}, T_{10})$ et $(R_{20}, T_{20})$. Par contre, les résistances de contre-réaction en continu $(R_{51}, R_{52})$ et $(R_{61}, R_{62})$ n'ont pas été conservées pour les raisons déjà mentionnées. Le mélangeur MIX est couplé directement aux bases des transistors $T_1$ et $T_2$. Ceci est rendu possible par la réduction de valeur de $R'_1$ et $R'_2$ précitée, laquelle permet de diminuer l'amplification des tensions de décalage (offset) à l'entrée de l'amplificateur, ce qui peut permettre d'éviter une contre-réaction en courant continu. Le mélangeur est couplé aux sorties de l'amplificateur (émetteurs des transistors $T_5$ et $T_6$) par une résistance en série avec un condensateur respectivement (R, C) pour $T_5$ et (R', C') pour $T_6$. En général, C et C' peuvent être de l'ordre de 10 pF, ce qui correspond à des condensateurs intégrables (voir la demande de brevet européen EP 414328).

Une liaison directe est représentée à la figure 4. Il est souhaitable d'omettre les condensateurs C et C' ne serait ce qu'en raison de la surface occupée par ceux-ci sur un circuit intégré. Une autre raison est le risque d'oscillation à très basse fréquence lorsque le filtre ($R_o$, $L_0$, $C_0$) n'est pas connecté. Selon la figure 4, la liaison est réalisée directement par des résistances de contre-réaction R et R' entre le mélangeur et les sorties de l'amplificateur. Pour ce faire, on compense la chute de tension en augmentant le courant des sources de courant $(R_{10}, T_{10})$ et $(R_{20}, T_{20})$ d'une valeur $\Delta I$ égale à :

$$\Delta I = \frac{V_A - V_D}{R}$$

$V_A$ = potentiel au point A (base de $T_1$) en continu.

$V_D$ - $V_A$ = chute de tension dans la résistance de contre-réaction (R ou R').

Il convient également de réduire la valeur des résistances $R_0$ et $R'_o$ du mélangeur pour maintenir l'égalité des tensions :

$$R_M = \frac{V_A}{I_{10} + \Delta I}$$

$I_{10}$ = intensité des sources de courant $(R_{10}, T_{10})$ et $R_{20}, T_{10})$ dans le cas de la figure 3.

**Revendications**

1. Amplificateur différentiel du type cascode comprenant un étage différentiel comportant un premier ($T_1$) et un deuxième transistor ($T_2$) dont les collecteurs sont connectés à une charge active constituée par le trajet collecteur-émetteur respectivement d'un troisième ($T_3$) et d'un quatrième ($T_4$) transistor en série respectivement avec une première ($R_1$) et une deuxième résistance ($R_2$) dont une borne est connectée à une première source de tension d'alimentation ($V_{cc}$), les troisième ($T_3$) et quatrième transistors ($T_4$) ayant leur base connectée à une source de tension de référence ($V_{ref}$) caractérisé en ce qu'il comporte un premier condensateur ($C_1$) disposé entre les trajets collecteur-émetteur du troisième ($T_3$) et du premier transistor ($T_1$), ainsi qu'un deuxième condensateur ($C_2$) disposé entre les trajets collecteur-émetteur du quatrième ($T_4$) et du deuxième transistor ($T_2$), en ce qu'il comporte une troisième ($R'_1$) et une quatrième ($R'_2$) résistance disposée entre ladite première source de tension d'alimentation ($V_{cc}$) et le trajet collecteur-émetteur de respectivement le premier ($T_1$) et le deuxième ($T_2$) transistor et en ce qu'il comporte une première ($I'_{13}$) et une deuxième ($I'_{14}$) source de courant connectée à l'émetteur respectivement des troisième ($T_3$) et quatrième ($T_4$) transistors de manière à fournir un courant au troisième ($T_3$) et au quatrième ($T_4$) transistor.

2. Amplificateur différentiel selon la revendication 2 caractérisé en ce que la première et la deuxième source de courant sont constituées par une cinquième ($R'_{13}$) et une sixième ($R'_{14}$) résistance connectée entre l'émetteur respectivement du troisième ($T_3$) et du quatrième ($T_4$) transistor et une deuxième source de tension d'alimentation.

3. Mélangeur-oscillateur comportant un mélangeur attaquant les entrées d'un amplificateur différentiel dont les sorties sont connectées à un filtre, caractérisé en ce que l'amplificateur différentiel est selon une des revendications 1 ou 2.

4. Mélangeur-oscillateur selon la revendication 3 caractérisé en ce que le mélangeur est directement couplé aux entrées de l'amplificateur différentiel.

5. Mélangeur-oscillateur selon la revendication 4 caractérisé en ce que le mélangeur est couplé aux sorties de l'amplificateur différentiel à travers uniquement une cinquième ($R$) et une sixième ($R'$) résistance.

6. Mélangeur-oscillateur selon une des revendications 3 à 5 caractérisé en ce qu'il comporte un cinquième ($T_5$) et un sixième ($T_6$) transistor disposés en émetteur-suiveur et ayant de ce fait leur base connectée au collecteur respectivement des troisième ($T_3$) et quatrième ($T_4$) transistors.

**Patentansprüche**

1. Differenzverstärker vom Kaskode-Typ mit einer Differenzstufe, die einen ersten ($T_1$) und einen zweiten ($T_2$) Transistor aufweist, deren Kollektor-Elektroden mit einer aktiven Last verbunden sind, die durch die betreffenden Kollektor-Emitterstrecken eines dritten ($T_3$) und eines vierten ($T_4$) mit einem ersten ($R_1$) bzw. zweiten ($R_2$) Widerstand reihengeschalteten Transistors gebildet sind, wobei ein Anschluß mit einer ersten Speisespannungsquelle ($V_{cc}$) verbunden ist, wobei die Basis-Elektroden des dritten ($T_3$) und des vierten ($T_4$) Transistors mit einer Bezugsspannungsquelle ($V_{ref}$) verbunden sind, dadurch gekennzeichnet, daß er einen ersten Kondensator ($C_1$) aufweist, der zwischen den Kollektor-Emitterstrecken des dritten Transistors (T3) und des ersten Transistors ($T_1$) vorgesehen ist, und einen zweiten Kondensator ($C_2$), der zwischen den Kollektor-Emitterstrecken des vierten Transistors ($T_4$) und des zweiten Transistors ($T_2$) vorgesehen ist, daß er einen dritten Widerstand ($R'_1$) und einen vierten Widerstand ($R'_2$) aufweist, die zwischen der genannten ersten Speisespannungsquelle ($V_{cc}$) und der Kollektor-Emitterstrecke des ersten ($T_1$) bzw. des zweiten ($T_2$) Transistors vorgesehen sind, und daß er eine erste ($I'_{13}$) und eine zweite ($I'_{14}$) Stromquelle aufweist, die mit der Emitter-Elektrode des dritten ($T_3$) bzw. des vierten ($T_4$) Transistors verbunden ist zum Liefern eines Stromes zu dem dritten ($T_3$) und dem vierten ($T_4$) Transistor.

2. Differenzverstärker nach Anspruch 1, dadurch gekennzeichnet, daß die erste und die zweite Stromquelle durch einen fünften ($R'_{13}$) und einen sechsten ($R'_{14}$) Widerstand zwischen der Emitter-Elektrode des dritten ($T_3$) bzw. vierten ($T_4$) Transistors und einer zweiten Speisespanungsquelle gebildet sind.

3. Oszillatormischer mit einem Mischer zum Betreiben der Eingänge eines Differenzverstärkers' dessen Ausgänge mit einem Filter verbunden sind, dadurch gekennzeichnet, daß der Differenzverstärker ein Verstärker nach Anspruch 1 oder 2 ist.

4. Oszillatormischer nach Anspruch 3, dadurch gekennzeichnet, daß der Mischer unmittelbar mit den Eingängen des Differenzverstärkers gekoppelt ist.

5. Oszillatormischer nach Anspruch 4, dadurch gekennzeichnet, daß der Mischer nur über einen fünften (R) und einen sechsten (R') Widerstand mit den Ausgängen des Differenzverstärkers gekoppelt ist.

6. Oszillatormischer nach einem der Ansprüche 3 bis 5, dadurch gekennzeichnet, daß er einen fünften Transistor ($T_5$) und einen sechsten Transistor ($T_6$) aufweist, die als Emitterfolger geschaltet sind und deswegen mit ihren Basis-Elektroden mit der Kollektor-Elektrode des dritten Transistors ($T_3$) bzw. des vierten Transistors ($T_4$) verbunden sind.

**Claims**

1. A differential amplifier of the cascode type comprising a differential stage which comprises a first ($T_1$) and a second ($T_2$) transistor whose collectors are connected to an active load formed by the respective collector-emitter paths of a third ($T_3$) and a fourth ($T_4$) transistor in series with a first ($R_1$) and a second ($R_2$) resistor, respectively, having one terminal connected to a first supply voltage source ($V_{cc}$), the third ($T_3$) and the fourth ($T_4$) transistor having their bases connected to a reference voltage source ($V_{ref}$), characterized in that it comprises a first capacitor ($C_1$), arranged between the collector-emitter paths of the third transistor ($T_3$) and of the first transistor ($T_1$), and a second capacitor ($C_2$), arranged between the collector-emitter paths of the fourth transistor ($T_4$) and of the second transistor ($T_2$), in that it comprises a third resistor ($R'_1$) and a fourth resistor ($R'_2$), arranged between said first supply voltage source ($V_{cc}$) and the collector-emitter path of the first ($T_1$) and of the second ($T_2$) transistor, respectively, and in that it comprises a first ($I'_{13}$) and a second ($I'_{14}$) current source connected to the emitter of the third ($T_3$) and the fourth ($T_4$) transistor, respectively, so as to supply a current to the third ($T_3$) and to the fourth ($T_4$) transistor.

2. A differential amplifier as claimed in Claim 1, characterized in that the first and the second current source are constituted by a fifth ($R'_{13}$) and a sixth ($R'_{14}$) resistor connected between the emitter of the third ($T_3$) and of the fourth ($T_4$) transistor, respectively, and a second supply voltage source.

3. An oscillator-mixer comprising a mixer driving the inputs of a differential amplifier having its outputs connected to a filter, characterized in that the differential amplifier is an amplifier as claimed in Claim 1 or 2.

4. An oscillator-mixer as claimed in Claim 3, characterized in that the mixer is coupled directly to the inputs of the differential amplifier.

5. An oscillator-mixer as claimed in Claim 4, characterized in that the mixer is coupled to the outputs of the differential amplifier only *via* a fifth (R) and a sixth (R') resistor.

6. An oscillator-mixer as claimed in any one of the Claims 3 to 5, characterized in that it comprises a fifth transistor ($T_5$) and a sixth transistor ($T_6$) arranged as emitter followers and therefore having their bases connected to collector of the third transistor ($T_3$) and the fourth transistor ($T_4$), respectively.

FIG.1

FIG.4

FIG.2

FIG.3